**Europäisches Patentamt**

**European Patent Office**

**Office européen des brevets**

(11) Publication number: **0 117 132**
**B1**

(12) **EUROPEAN PATENT SPECIFICATION**

(45) Date of publication of patent specification: **27.12.89**

(51) Int. Cl.⁴: **H 03 M 1/50, G 01 G 23/37**

(21) Application number: **84301007.5**

(22) Date of filing: **16.02.84**

(54) **Double integrating-type analog-to-digital converter.**

(30) Priority: **16.02.83 JP 25149/83**
**18.02.83 JP 26642/83**

(43) Date of publication of application:
**29.08.84 Bulletin 84/35**

(45) Publication of the grant of the patent:
**27.12.89 Bulletin 89/52**

(84) Designated Contracting States:
**BE DE GB NL SE**

(56) References cited:
**EP-A-0 072 144**
**US-A-4 204 197**

(73) Proprietor: **KABUSHIKI KAISHA ISHIDA KOKI SEISAKUSHO**
**44, Shogoin Sannou-cho Sakyo-ku**
**Kyoto-shi Kyoto 606 (JP)**

(72) Inventor: **Naito, Kazufumi**
**Haitsu-Nishiohtsu 302 4-5, Yanagasaki**
**Ohtsu-shi Shiga (JP)**

(74) Representative: **Fane, Christopher Robin King et al**
**HASELTINE LAKE & CO. Hazlitt House 28**
**Southampton Buildings Chancery Lane**
**London, WC2A 1AT (GB)**

## Description

This invention relates to a double integrating-type analog-to-digital converter, for example for use in an electronic weigher.

In an analog-to-digital converter of the double-integrating type, the analog voltage to be converted is applied to integrating circuitry which integrates that voltage, so as to produce a steadily increasing output signal, under the control of microcomputer timing means. Upon expiry of a preset time interval the timing means cause a reference voltage, opposite in polarity to the said analog voltage, to be applied to the integrating circuitry in place of the analog voltage. The output voltage signal then decreases steadily from its peak value, attained at the end of the preset time interval, until it reaches a preset value, and the digital output signal of the converter is produced by means of counting circuitry which measures the period of time taken for the output voltage signal to fall from its peak value to that preset value.

Such an analog-to-digital converter (referred to hereinafter as an "A/D converter") is suitable for slow measurements at high accuracy and therefore finds use in instruments such as digital voltmeters and electronic weighers. US—A—4,204,197 (Loshbough et al) discloses an A/D converter having the above-mentioned features for use in an electronic weighing system.

Prior A/D converters of this type suffer from a disadvantage in that the maximum digital output value is limited by the capacity of a counter or register employed in the counting circuitry for measuring the reverse integration time, i.e. the period of time over which the reference voltage is integrated. As a result, the resolution of prior A/D converters of this type cannot be raised at will. This means that the basic construction of the circuitry must be modified when a change in the resolution of the converter is required.

It is desirable to provide a double integrating type A/D converter in which the maximum digital output value can be varied selectively, without changing the construction of the counter used, thereby making it possible to vary at will the resolution of the converter.

According to the present invention there is provided an analog-to-digital converter of the type in which the analog voltage to be converted is applied to integrating circuitry which integrates that voltage, so as to produce a steadily increasing output voltage signal, under the control of microcomputer means which upon expiry of a preset time interval cause a reference voltage, opposite in polarity to the said analog voltage, to be applied to the integrating circuitry in place of the said analog voltage so that the said output voltage signal then decreases steadily from its peak value, attained at the end of the said preset time interval, until that signal reaches a preset value; the digital output signal of the converter being produced by means of counting circuitry which measures the period of time taken for the said output voltage signal to fall from the said peak value to the said preset value; characterised in that the said counting circuitry comprises a counter, operable cyclically to count up to a predetermined number and then produce an overflow signal, and in that said microcomputer means are operable to derive the said digital output signal from the count recorded in the said counter at the end of the said period and the number of any such overflow signals provided by the said counter during the course of the said period.

Such an arrangement wherein a microcomputer counts the number of times the counter overflows to produce the digital output signal from the overflow count, together with the count recorded in the counter, permits the output count (for a given analog voltage being converted) to be increased irrespective of the capacity of the counter. This permits the resolution of the A/D converter to be raised as required.

It will be appreciated that a variety of electronic weighers having different weighing capacities and weighing accuracies are available. In producing a large variety of weighers, it is desirable to use therein identical load cells, as weight sensors, and identical double-integrating A/D converters, so as to keep to a minimum the total number of different components involved. However, in a prior art weigher incorporating an A/D converter with a fixed input voltage range, in order to reduce the weighing range without reducing the resolution of the A/D converter, it becomes necessary to amplify the input to the A/D converter, requiring the provision of a pre-amplifier circuit designed for the particular application. For example, in a case where three electronic weighers having respective weighing capacities of 5 kg, 10 kg and 20 kg are to be manufactured using a load cell designed to give an output voltage of 20 mv when weighing 20 kg and a double-integrating A/D converter whose maximum input voltage is 2 v, pre-amplifier circuits having amplifications of 100, 200 and 400 are required for the electronic weighers having the weighing capacities of 20 kg, 10 kg and 5 kg respectively. Such a need to provide different preamplifiers for different applications can be obviated by employing circuitry (for example as in US 4,204,197) that permits selective adjustment of the preset time interval over which the analog input voltage is integrated.

Accordingly, in a preferred embodiment of the present invention the microcomputer means of the A/D converter are selectively adjustable to vary the said preset time interval.

Reference will now be made by way of example, to the accompanying drawings, in which:

Figure 1 is a block diagram of a double integrating-type A/D converter, not embodying the present invention;

Figure 2 is a time chart of signals associated with the converter of Figure 1;

Figures 3 and 4 are block diagrams of two further double-integrating type A/D converters not embodying the present invention;

Figure 5 is a block diagram of a double-integrating type A/D converter constituting a first embodiment of the present invention;

Figures 6 and 7 are respective block diagrams of second and third embodiments of the present invention;

Figure 8 is a flowchart illustrating an example of the operation of a control unit (5e) included in the embodiment shown in Figure 6;

Figure 9 is a flowchart illustrating details of a step 4 in the flowchart of Figure 8;

Figure 10 is a flowchart illustrating a portion of the operation of a control unit (5f) included in the embodiment of Figure 7;

Figures 11 to 13 are block diagrams illustrating respectively how the double integrating-type A/D converters of Figures 1, 3 and 4 may be used in a weight sensing section of an electronic weigher;

Figure 14 is a timechart showing the relationship between output count and the integrating interval of an analog signal where the integrating interval is changed; and

Figure 15 is a block diagram illustrating how each of the arrangements of Figures 11 to 13 can be modified to make use of an embodiment of the present invention.

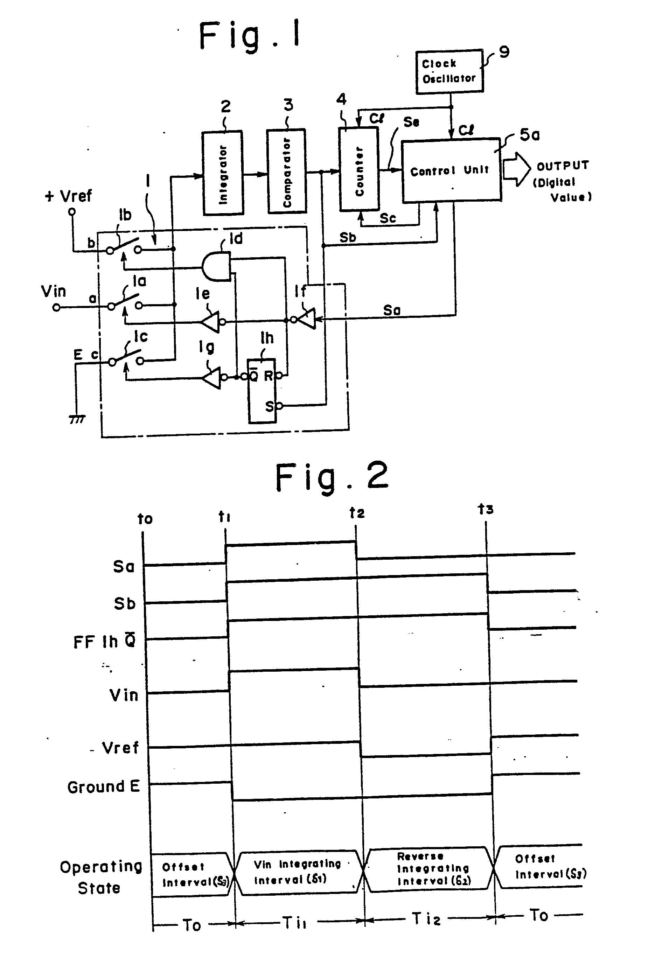

The A/D converter of Figure 1 includes an analog switch 1 the input side of which switches between three inputs, namely a reference voltage $V_{ref}$, an analog voltage $V_{in}$, the magnitude of which is to be measured, and a ground potential E. The output terminal of the analog switch 1 is connected to an input circuit of an integrator 2. The analog switch 1 includes switching sections 1a, 1b, 1c each comprising a functional device such as a field-effect transistor (FET), an AND gate 1d, inverters 1e, 1f, 1g, and a flip-flop (FF) 1h. The $\bar{Q}$ output of the FF 1h is connected to the input side of the inverter 1g and to one input terminal of the AND gate 1d, the outputs of which actuate (i.e. open or close) the switching sections 1b and 1c, respectively. The output terminal of the inverter 1f is connected to the reset terminal R of the FF 1h, the input side of the inverter 1e and the other input terminal of the AND gate 1d. The output of the inverter 1e actuates the switching section 1a. The connections to the set terminal S of the FF 1h and to the input of the inverter 1f will be described hereinbelow.

The output of the analog switch 1 is an analog voltage connected to the input of the integrator 2, which first integrates the analog input voltage over a preset time interval. Reverse integration is then commenced as described below. The output voltage provided by the integrator 2 is applied as an input to a comparator 3, which proceeds to compare the integrator output voltage with the substantially zero voltage (offset error voltage) at which the integration of the analog input voltage started. When equivalence between these two voltages is achieved, the comparator 3 produces a count stop signal Sb which is applied to the set terminal S of the FF 1h, an input to a counter 4, and an input to a control unit 5a. In actuality, the count stop signal Sb is constituted by a change from a high to a low logic level, the output signal of the comparator 3 being low when its input signal is zero and high when its input signal is less than zero. The counter 4 was reset at the start of reverse integration by a reset command Sc from the control unit 5a, described in detail hereinbelow. The counter 4 started counting at the instant it was reset, and stops counting in response to the count stop signal Sb from the comparator 3. The counter 4 produces a signal Se indicative of the value of the recorded count.

The control unit 5a comprises a microcomputer having a central processor, program memory, working memory and input/output circuit and, in addition to the count stop signal Sb, receives as an input the signal Se indicative of the count recorded in the counter 4. In accordance with a program stored in the program memory, the control unit 5a produces a switch command Sa connected to the input side of the inverter 1f, and the abovementioned reset command Sc connected to the reset terminal of the counter 4. The output of the control unit 5a is a digital signal obtained by integration of the analog signal $V_{in}$, which is the signal to be measured. The counter 4 and control unit 5a are clocked by a clock signal C1 of a suitable frequency, the signal being produced by a clock oscillator 9.

The integration operation performed by the double integrating-type A/D converter of Fig. will be described in conjunction with the timechart of Fig. 2. The first step is to actuate the analog switch 1 in accordance with a switch command Sa, produced by the control unit 5a, and the signal Sb from the comparator 3. Specifically, as shown in Fig. 2, the integrator 2 is subjected to a zero-offset correction over an offset interval $T_0$ that includes a point in time $t_0$. The FF 1h is in the set state during the offset interval $T_0$, so that the $\bar{Q}$ output of FF 1h is at the low level, and the output of inverter 1g is high. The switching section 1c is closed as a result, thereby applying the ground potential E to the inverter 2. This in effect applies the zero-offset adjustment to the double-integrating A/D converter.

Next, at time $t_1$, the control unit 5a produces the switch command Sa (actually a low-to-high level transition), causing the $\bar{Q}$ output terminal of the FF 1h to assume the high level.

The output of inverter 1g goes low to open the switching section 1c, while the output of inverter 1e goes high to close the switching section 1a. This causes the analog signal $V_{in}$ to be applied to the input terminal of the integrator 2, which now begins integrating the signal. The integration of the analog signal $V_{in}$ performed by the double-integrating A/D converter takes place over an interval $T_{i1}$. When the integrator 2 produces an analog output signal as a result of the integration operation, the output of the comparator 3 assumes the high logic level. Thus, there is no change in the operation of the double-integrating A/D converter despite the transition of the signal Sb from the low to the high level.

At time $t_2$, which is the instant at which the predetermined interval of time $T_{i1}$ elapses, with the interval being determined by microcomputer timing means to be described below, the switch command Sa from the control unit 5a drops to the low level, whereupon the output of the inverter 1e goes low to open the switching section 1a, thereby ending the integration of the analog input signal $V_{in}$. At the same time, the output of the AND gate 1d goes high to close the switching section 1b and apply the reference voltage $V_{ref}$, of polarity opposite to that of the analog signal $V_{in}$, to the integrator 2, whereby a reverse integration is carried out. As a result of performing the reverse integration, the output voltage produced by the integrator 2 becomes zero in magnitude at time $t_3$, at which time the output of the comparator 3 makes a transition from the high to low level, with the negative-going transition serving as the count stop signal Sb. When this occurs, FF 1h is set, sending the $\bar{Q}$ output thereof to the low level. This in turn sends the output of the inverter 1g high to close the switching section 1c, and disables the AND gate 1d to open the switching section 1b. The Earth voltage E therefore is applied to the integrator 2, thereby restoring the offset interval $T_0$ at time $t_3$.

The foregoing operation is repeated periodically in accordance with the program stored in the control unit 5a. More specifically, the control unit 5a is programmed to include a working sequence and working time, namely a period $S_1$ and interval $T_{11}$ for integrating the analog input signal $V_{in}$, and an offset period $S_3$ and offset interval $T_0$.

In particular, the control unit 5a is so designed that the integrating interval $T_{11}$ over which the analog input signal $V_{in}$ is integrated can be preset in the program to a value appropriate to the particular application, that is to a value corresponding to the range of input voltages that will normally be encountered in that application. To this end the control unit 5a is provided with a so-called software timer, the program for controlling that timer being appropriately modified for different applications so as to set appropriate respective intervals $T_{11}$ over which the analog input signal $V_{in}$ is to be integrated.

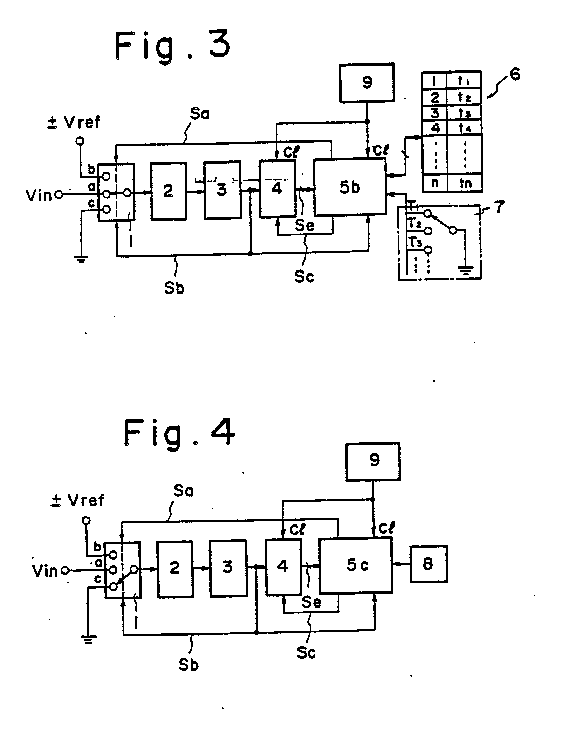

Figure 3 is a block diagram illustrating an arrangement in which the interval $T_{11}$ for integrating the analog input signal $V_{in}$ can be set by setting means provided external to the double-integrating A/D converter. The analog switch 1 is illustrated as a simple block, with other portions similar to those of Figure 1 being designated by like reference characters. These portions will not be described in detail again in order to avoid prolixity. In Figure 3, the control unit 5b, the construction of which is similar to the construction of the control unit 5a in Figure 1, is provided with a memory 6 for storing a plurality of different set times $t_1$, $t_2$, $t_3$,...$t_n$, and with designating means 7 for selecting a set time. The designating means 7 comprises a suitable changeover switch having a dial or the like which, by being manipulated, selects the desired set time. When this is done, an integrating interval corresponding to the time selected by the designating means 7 is chosen within the memory 6. When a program step for setting the integrating interval $T_{11}$ is reached, the integrating interval $T_{11}$ selected from the memory 6 is read into the control unit 5a, and the analog input signal $V_{in}$ is thereupon caused to be integrated over that selected time interval.

Fig. 4 is a block diagram illustrating another embodiment in which the interval $T_{11}$ for integrating the analog input signal $V_{in}$ can be set by setting means provided external to the double-integrating A/D converter. As in Fig. 3, the analog switch 1 is illustrated as a simple block, with other portions similar to those of Fig. 1 being designated by like reference characters. These portions need not be described again in detail. In Fig. 4, the control unit 5c, the construction of which is similar to the construction of the control unit 5a in Fig. 1, is provided with setting means 8 for setting the interval $T_{11}$ over which the analog input signal $V_{in}$ is integrated. The seting means 8 is provided with, e.g., a digital switch or numeric key arrangement for producing a set time output in the form of a digital value applied to the control unit 5c. The setting means 8 is set to the desired integrating interval $T_{11}$ before the double-integrating A/D converter is set into operation.

In the three arrangements of Figs. 1, 3 and 4, a suitable integrating interval $T_{11}$ is selected based upon the particular application of the double-integrating A/D converter and the level of the input signal. A desired conversion precision in the double-integrating A/D converter is maintained, for different applications, by selecting relatively long integrating intervals in cases where the input signal levels are to be low, and relatively short integrating intervals where the input signal levels are to be high. In this way, in double-integrating A/D converters of this type, adjustment of the analog input signal levels can be rendered unnecessary.

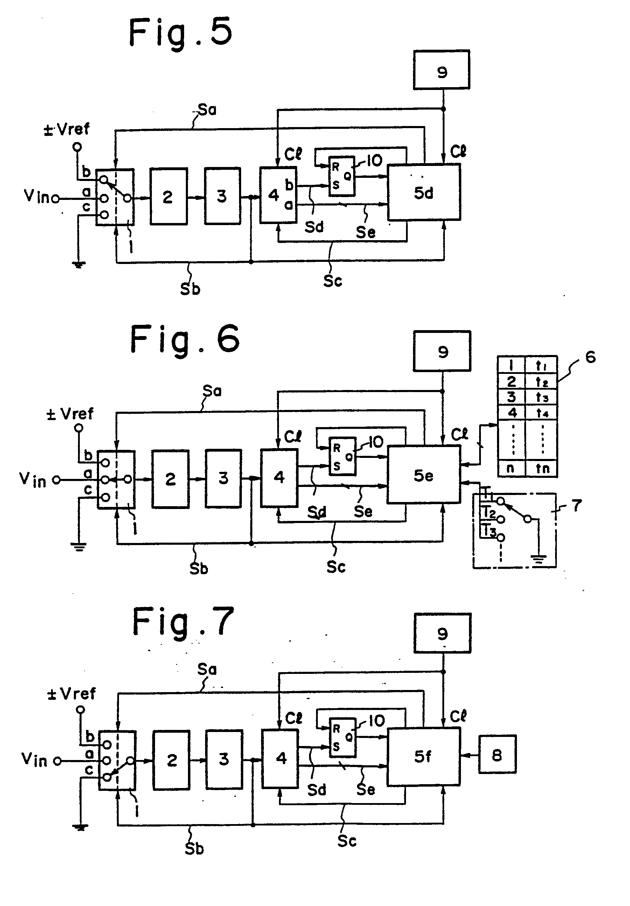

In each of the foregoing arrangements, the counter 4 has a large capacity and, hence, is relatively high in cost, regardless of the length of the reverse integrating interval $T_{12}$. This drawback is eliminated, by means of an overflow counting facility in the embodiments illustrated in Figures 5 through 7, as will now be described.

Figure 5 is a block diagram in which portions similar to those of Figure 1 are designated by like reference characters. The counter 4 has a construction similar to that of the counter 4 in Figure 1 but need not have a very large capacity. The counter 4 is provided with a terminal $a$ at which the signal Se indicative of the recorded count appears, and with an overflow terminal $b$ at which an overflow signal Sd is produced whenever the recorded count overflows. The overflow terminal $b$ is connected to the set terminal S of a FF 10, the Q output of which is connected to an input of the control unit, here designated at 5d. The FF 10 is reset by a reset signal produced by the control unit 5d. The purpose of the FF 10 is to latch the overflow signal Sd from the counter 4, thereby to extend the duration of that signal. Accordingly, when the overflow signal Sd is applied to the set terminal S of the FF 10, the Q output terminal thereof goes high. Upon subsequently reading in the high level signal at the Q output of the FF10, the control unit 5d computes a total output count from the prevailing count Se and from the number of overflows recorded up to that point in time. In this way the output count of the double-integrating A/D converter is increased irrespective of the construction of the counter 4. This makes it possible to raise the resolution of the converter at will.

Figures 6 and 7 illustrate second and third embodiments of the present invention, having time interval setting means as described with reference to Figures 3 and 4 respectively. The FF 10 is provided in each case for latching the overflow signal Sd produced by the counter 4. These embodiments operate in the same fashion as the embodiment shown in Figure 5. The control unit is designated by 5e in Figure 6, and by 5f in Figure 7.

It should be noted that the FF 10 can be deleted from the arrangements of Figures 5 to 7 if a signal indicative of the most significant digit of the counter 4 is used as the overflow signal.

The control operations performed by the control units 5d through 5f in the foregoing embodiments will now be described. It should be noted, however, that the control operations performed by the control unit 5d in Fig. 5, are broadly similar to the control operations executed by the control unit 5e of Fig. 6, so that a description solely of the latter control operations will suffice.

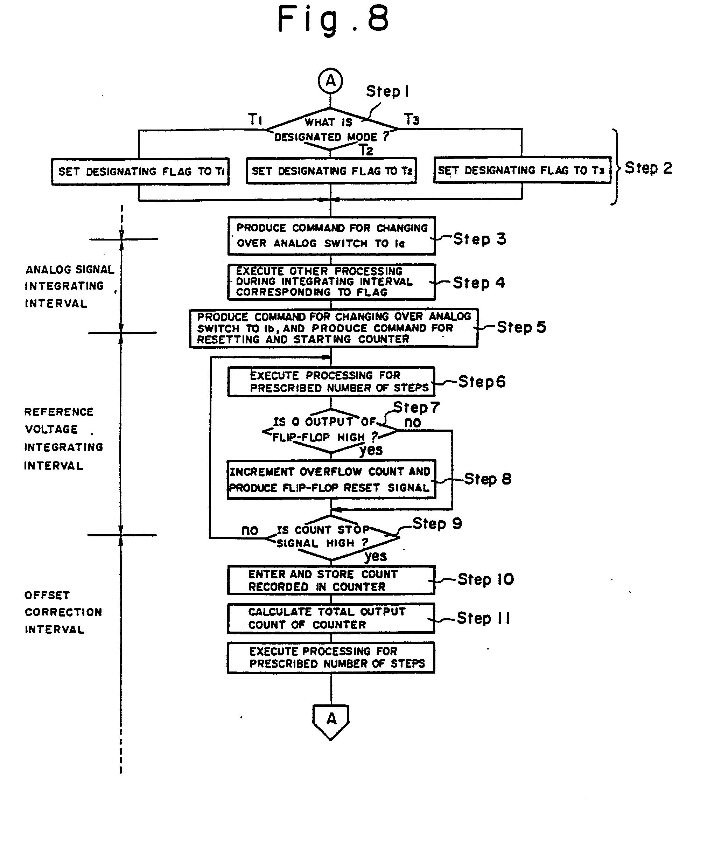

An example of the control performed by the control unit 5e of Fig. 6 is illustrated in the flowchart of Fig. 8. We shall assume that the switching section 1c of the analog switch 1 is in the closed state owing to the count stop signal Sb from the comparator 3 at the start of operation. When the control program is executed under these conditions, the control unit 5e in step 1 checks the designating means 7 to ascertain the integrating interval designated thereby. The control unit 5e then executes step 2, in which a designating flag corresponding to the designated interval is set, followed by step 3 in which the command Sa is issued to open the switching section 1c and close the switching section 1a of the logic switch 1. The integrator 2 starts integrating the analog input signal $V_{in}$ as a result of these process steps.

While the control unit 5e is executing other processing (arithmetic and logic processing, display processing, etc.) in step 4, it also monitors the integrating interval on the basis of these process steps and, when equivalence is detected between the integrating interval and the set time corresponding to the designating flag, executes step 5, wherein the command Sa is issued to close the switching section 1b of the analog switch 1, together with the command Sc for resetting and starting the counter 4. As a result, integration of the analog input signal $V_{in}$ ends, followed by starting the integration of the reference voltage $V_{ref}$ and the counting operation of the counter 4.

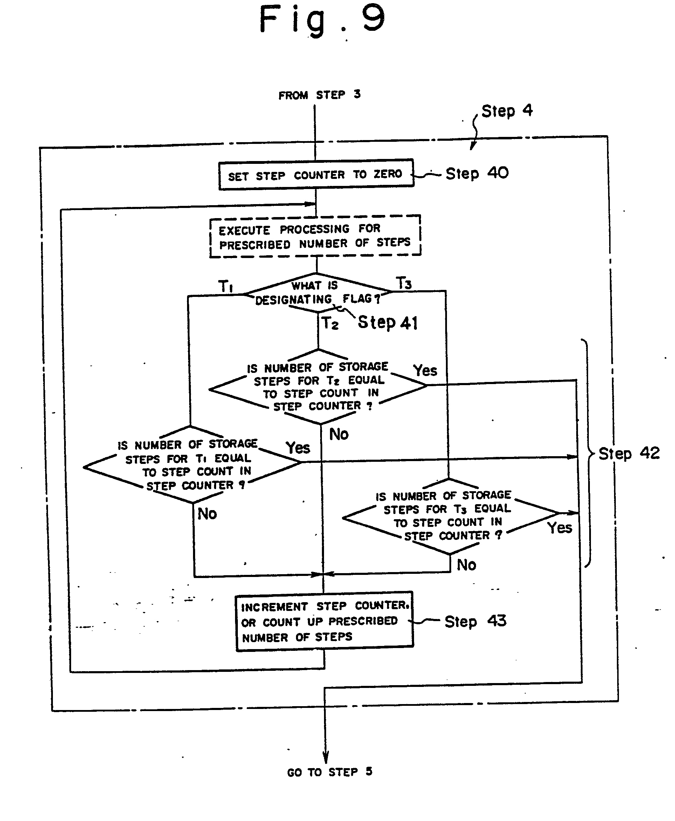

Fig. 9 is an example of a flowchart indicating the details of step 4 in the flowchart of Fig. 8. Here a step counter is used to monitor the integrating interval based on the number of process steps. More specifically, the step counter is set to zero in step 40, the aforementioned designating flag is examined in the next step 41, and the integrating interval corresponding to this designating flag is monitored in step 42. This last operation is performed by comparing the number of storage steps, which is equivalent to the designated integrating interval, with the count recorded in the step counter, and determining whether the two coincide. If the decision rendered is negative, namely non-coincidence, step 43 is executed, wherein the step counter is incremented (or, where the process step enclosed by the broken line is inserted, a prescribed number of steps is incremented), after which processing returns to step 41. When equivalence is established between the number of storage steps and the counted value in the step counter during repetition of the processing specified by the foregoing loop, the system leaves the loop and shifts to step 5 of the flowchart shown in Fig. 8. When other processing is executed concurrently with the processing associated with the foregoing loop, a certain number of steps are executed between step 43 and 41, as indicated by the broken line in Fig. 9.

When the processing of step 5 ends, the control unit 5e repeatedly checks the Q output of FF 10 and the count stop signal Sb from comparator 3 periodically. More specifically, in step 6, the control unit 5e executes the processing of a certain number of steps within an interval of time shorter than that needed for the counter 4 to produce the overflow signal Sd, and then checks the Q output of the FF 10 in step 7. Since the Q output initially is low, in this case processing skips step 8 and moves to step 9, where the count stop signal Sb is investigated. If the decision rendered in this block is that the count stop signal Sb is at the low level, the system returns to step 6 to repeat execution of the specified processing. Since the Q output of FF 10 will make the transition to the high level when the processing of step 6 ends, the overflow count is incremented and a signal is produced by the control unit 5e to reset FF 10 in the next step 8.

Next, in step 9, the control unit 5e checks the count stop signal Sb from the comparator 3. If Sb is low, the system returns to step 6; if high, integration of the reference voltage ends and, at the same time, the switching section 1c of the analog switch 1 is closed. Therefore, in step 10, the value of the count Se recorded in the counter 4 is entered and stored. This is followed by step 11, in which the control unit 5e calculates the total output count of the counter 4 from the overflow count, obtained in step 8, and from the value of the count recorded in the counter 4. Then, after a certain number of steps are executed, processing returns to step 1 and the foregoing control operation is repeated.

Note that alteration of the integrating interval as described above is unnecessary in the embodiment of Fig. 5. Therefore, the control unit 5d need not execute the foregoing steps 1, 2 and 41, 42.

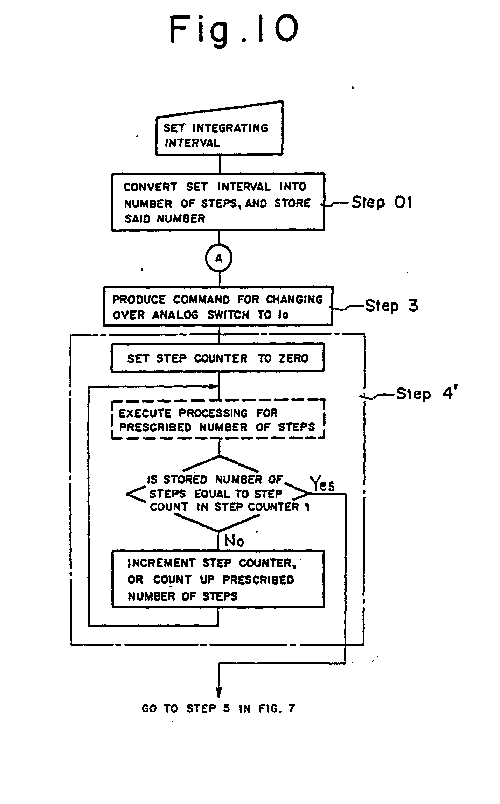

Fig. 10 is a flowchart illustrating an example of the control operation performed by the control unit 5f of Fig. 7. Only portions that differ from those shown in Fig. 8 are illustrated. In this case, rather than executing process steps 1 and 2, a process step 01 is inserted for converting the set time into a number of steps and for storing the result. The process step 4' inserted between steps 3 and 5 represents a simplification over the processing shown in Fig. 9.

Further, the control units 5d through 5f may be units for controlling solely the analog switch, or units

5

for executing other processing as well, such as processing associated with the keys, display and computations in an electronic weigher or the like.

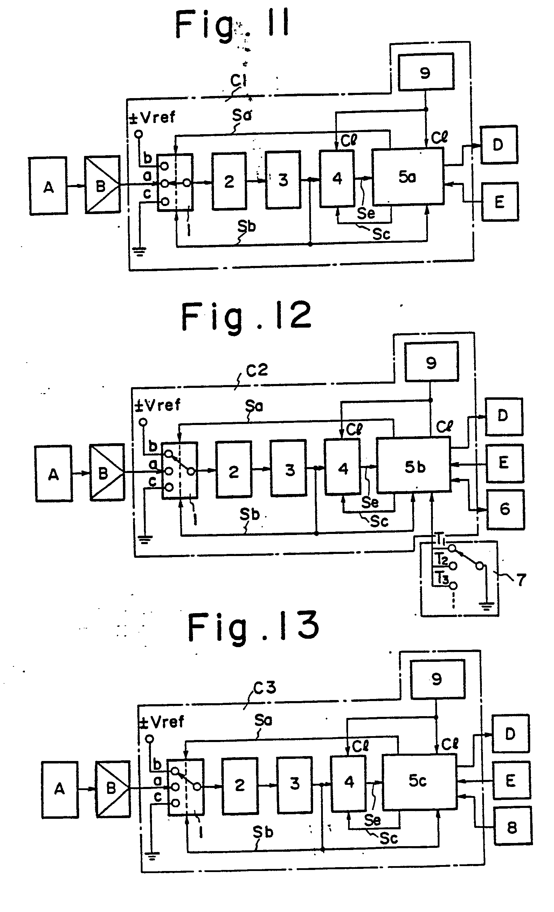

Described next will be examples of ways in which a double-integrating type A/D converter may be applied to the weight sensing section of an electronic weigher. A first example is illustrated in Figure 11 and includes a weight sensor A comprising a load cell for sensing the weight of a batch of articles and for producing an analog signal indicative of the sensed weight, an amplifier circuit B for amplifying the analog signal received as an input from the weight sensor A, and an A/D converter C1 which comprises the double-integrating A/D converter illustrated in Fig. 1, and which receives the amplified analog signal from the amplifier circuit B as an input thereto. A display device D is controlled by the control unit 5a to display such information as the measured weight of the article batch. The control unit 5a is provided with input means E for entering such information as the unit price and unit weight of the articles, tare, etc. The operation of the double-integrating A/D converter C1 is substantially the same as that of Figure 5, but without the overflow counting facility.

A second example of the use of such an A/D converter in a weight sensing device is illustrated in Figure 12 and includes the weight sensor A comprising a load cell, the amplifier circuit B for amplifying the output signal produced by the weight sensor A, and an A/D converter C2 comprising the double-integrating A/D converter of Figure 3 for converting the analog output of the amplifier circuit B into a digital signal. A third example is illustrated in Figure 13 and includes the weight sensor A comprising a load cell, the amplifier circuit B for amplifying the output signal produced by the weight sensor A, and an A/D converter of Figure 4 for converting the analog output of the amplifier circuit B into a digital signal.

Thus, in the electronic weigher illustrated in Figure 11, a software timer is pre-programmed to set the desired integration time interval. In the electronic weighers of Figures 12 and 13, the integration time interval to which the software timer is set can be altered by external control means. Such alteration can serve to avoid any need to change the amplification of the amplifier circuit B connected to the input side of the double-integrating A/D converters C2 or C3, thereby facilitating direct conversion of an electronic weigher, having a fixed-gain pre-amplifier B, into one having a different weighing capacity.

By way of example, assume that three electronic weighers having respective weighing capacities of 5 kg, 10 kg and 20 kg are to be manufactured using a weight sensor A designed to produce an output voltage of 20 mv when subjected to a load of 20 kg, and an amplifier circuit B having an amplification of 100. By setting the integrating interval of the analog signal from the weight sensor to the values shown in the following table, the maximum output count of the double-integrating A/D converters C1, C2, C3 can be made the same for each of the electronic weighers.

| Weighing capacity | Cell output | Amplifier output | Integrating interval | Output count |
|---|---|---|---|---|
| 5 kg | 5 mv | 0.5 v | 4×T | 10000 |
| 10 kg | 10 mv | 1 v | 2×T | 10000 |
| 20 kg | 20 mv | 2 v | 1×T | 10000 |

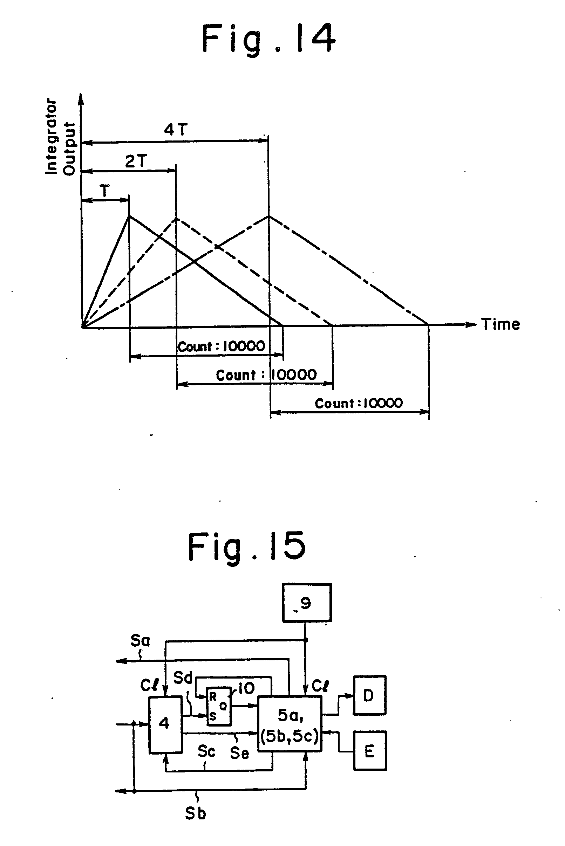

Fig. 14 is a timechart showing the relation between integrating interval and output count where the three double-integrating A/D converters C1, C2, C3 are operated over the integrating intervals given in the table above.

The control units 5a through 5c in the arrangements of Figs. 11 through 13 execute control operations ordinarily associated with an electronic weigher, in addition to the operations for controlling the analog switch.1. If necessary, however, separate control units can be provided, one exclusively for controlling the analog switch 1, the other for controlling the electronic weigher.

The selecting means 7 of Fig. 12 is constituted by a suitable changeover switch and is used as a weighing range changeover switch. The setting means 8 of Fig. 13 is constituted by, e.g., a digital switch, a group of numeric keys or a DIP switch and can even be used as span adjusting means. A span adjustment can be carried out by bringing the output count of the double-integrating A/D converter, when a reference counterweight is applied, into agreement with a reference count corresponding to the magnitude of the counterweight. Such an adjustment for bringing the output count into agreement with the reference count can readily be performed by regulating the integrating interval through use of the setting means 8.

Fig. 15 illustrates a circuit modification which can enable the output count, or resolution, of each of the double-integrating A/D converters C1, C2, C3 in the arrangements of Figs. 11 through 13 to be raised without requiring a higher output count from the counter 4 itself. More specifically, FF 10 in Figure 15 latches an overflow signal Sd from the counter 4. When the overflow signal is applied to the set terminal S of the FF 10, the Q output thereof goes high. When the high-level Q output is read in by the control unit 5a (5b, 5c), the latter increments an overflow count recorded in the control unit 5a (5b, 5c) and resets FF 10. Upon reading in the count stop signal Sb produced by the comparator 3, the control unit 5a (5b, 5c) calculates the total output count from the overflow count thus far and from the output count Se recorded in the counter 4. Thus, the output count of the double-integrating A/D converter is increased without changing

6

the construction of the counter 4 itself. The FF 10 can be deleted from the foregoing arrangements if a signal indicative of the most significant digit of the counter 4 is used as the overflow signal.

Thus an embodiment of the present invention can provide an A/D converter, the resolution or converting speed of which can be set at will in a simple manner, so that no modification in hardware is necessary when putting the converter to use in different applications. The converter may therefore be mass-produced to lower manufacturing costs. The converter can be such that the integrating interval of the analog signal can be altered at will, so the integrating interval for analog signals of a low input level can be lengthened to enable a high conversion precision to be maintained without the provision of a pre-amplifier. However, the use of a variable-gain level adjustment circuit (preamplifier in combination with an A/D converter embodying the present invention can enable both the analog signal input level and the integrating time interval to be selectively adjusted so that the converting speed and resolution of the converter can be controlled independently of one another.

## Claims

1. An analog-to-digital converter of the type in which the analog voltage ($V_{in}$) to be converted is applied to integrating circuitry (2) which integrates that voltage, so as to produce a steadily increasing output voltage signal, under the control of microcomputer means (5) which upon expiry of a preset time interval ($T_{i1}$) cause a reference voltage ($V_{ref}$), opposite in polarity to the said analog voltage, to be applied to the integrating circuitry in place of the said analog voltage so that the said output voltage signal then decreases steadily from its peak value, attained at the end of the said preset time interval, until that signal reaches a preset value; the digital output signal of the converter being produced by means of counting circuitry (4, 5, 10) which measures the period of time ($T_{i2}$) taken for the said output voltage signal to fall from the said peak value to the said preset value; characterised in that the said counting circuitry comprises a counter (4), operable cyclically to count up to a predetermined number and then produce an overflow signal (Sd), and in that said microcomputer means are operable to derive the said digital output signal from the count (Se) recorded in the said counter at the end of the said period ($T_{i2}$) and the number of any such overflow signals provided by the said counter during the course of the said period.

2. An analog-to-digital converter as claimed in claim 1, wherein the said microcomputer means are selectively adjustable to vary the said preset time interval ($T_{i1}$).

3. An analog-to-digital converter as claimed in claim 2, including a memory (6) for storing a plurality of different predetermined time intervals ($t_1, t_2...,t_n$) from which the said preset time interval ($T_{i1}$) can be selected.

4. An analog-to-digital converter as claimed in claim 1, 2 or 3, wherein the said predetermined number is the maximum count that can be recorded in the said counter, the said counting circuitry further comprising means (10) for latching the said overflow signal to extend the duration of that signal.

5. An analog-to-digital converter as claimed in claim 1, 2 or 3, wherein the said overflow signal is provided by the most significant bit in the said counter.

6. Electronic weighing apparatus having a weight sensor (A), for providing an analog output indicative of the weight of an article being weighed, and an analog-to-digital converter, as claimed in any preceding claim, connected for converting an analog voltage derived from the output of the said weight sensor.

7. Apparatus as claimed in claim 6, wherein the analog voltage applied to the said analog-to-digital converter is derived from the output of the said weight sensor by a fixed-gain amplifier circuit (B) connected therebetween.

## Patentansprüche

1. Analog-Digital-Wandler bei dem die zu wandelnde Analog-Spannung ($V_{in}$) einer Integrationsschaltung (2) zugeführt wird, welche diese Spannung unter Steuerung durch eine Mikrocomputervorrichtung (5) integriert, um ein stetig zunehmendes Ausgangsspannungssignal zu erzeugen, wobei die Mikrocomputervorrichtung bei Ablauf eines voreingestellten Zeitintervalls ($T_{i1}$) veranläßt, daß eine Referenzspannung ($V_{ref}$) mit zu der Analog-Spannung umgekehrter Polarität der Integrationsschaltung anstelle der Analog-Spannung zugeführt wird, so daß das Ausgangsspannungssignal dann von seinem am Ende des voreingestellten Zeitintervalls erreichten Spitzen-Wert stetig abnimmt, bis das Signal einen vorbestimmten Wert erreicht; wobei das digitale Ausgangssignal des Konverters durch eine Zählschaltung (4, 5, 10) erzeugt wird, welche die Zeitspanne ($T_{i2}$) mißt, die das Ausgangsspannungssignal benötigt, um von dem Spitzen-Wert auf den vorbestimmten Wert zu fallen; dadurch gekennzeichnet, daß die Zählschaltung einen Zähler (4) aufweist, der derart zyklisch betreibbar ist, daß er bis zu einer vorbestimmten Zahl zählt und dann ein Überlaufsignal (Sd) erzeugt, und daß die Mikrocomputervorrichtung derart betreibbar ist, daß sie das digitale Ausgangssignal aus dem in dem Zähler (4) am Ende der genannten Zeitspanne ($T_{i2}$) gespeicherten Zählerstand (Se) und der Anzahl der durch den Zähler während der Dauer der genannten Zeitspanne gelieferten Überlaufsignale ableitet.

2. Analog-Digital-Wandler nach Anspruch 1, bei dem die Mikrocomputervorrichtung wahlweise derart einstellbar ist, daß sie das voreingestellte Zeitintervall ($T_{i1}$) verändert.

3. Analog-Digital-Wandler nach Anspruch 2, mit einem Speicher (6) zum Speichern mehrerer

unterschiedlicher vorbestimmter Zeitintervalle $(t_1, t_2...t_n)$, aus denen das genannte voreingestellte Zeitintervall $(T_{I1})$ ausgewählt werden kann.

4. Analog-Digital-Wandler nach Anspruch 1, 2 oder 3, bei dem die vorbestimmte Anzahl der in dem Zähler speicherbare maximale Zählerstand ist, wobei die Zählschaltung ferner Mittel (10) aufweist, die das Überlaufsignal halten, um die Dauer dieses Signals zu verlängern.

5. Analog-Digital-Wandler nach Anspruch 1, 2 oder 3, bei dem das Überlaufsignal von dem höchstwertigen Bit im Zähler geliefert wird.

6. Elektronische Wägenvorrichtung mit einem Gewichtssensor (A) zum Liefern eines analogen Ausgangssignals, das das Gewicht eines gewogenen Artikels angibt, und einem Analog-Digital-Wandler, nach einem der vorhergehenden Ansprüche, der zum Umwandeln einer von dem Ausgangssignal des Gewichtssensors abgeleiteten Analog-Spannung geschaltet ist.

7. Vorrichtung nach Anspruch 6, bei welcher die dem Analog-Digital-Wandler zugeführte Analog-Spannung von dem Ausgangssignal des Gewichtssensors durch eine zwischen diesen geschaltete Verstärkerschaltung (B) mit fester Verstärkung abgeleitet wird.

## Revendications

1. Convertisseur analogique à digital du type dans lequel la tension analogique $(V_{in})$ à convertir est appliquée à un circuit intégrateur (2) qui intègre cette tension de façon à produire un signal de tension de sortie croissant constamment sous la commande de moyens à micro-ordinateur (5) qui, lors de l'expiration d'un intervalle de temps $(T_{I1})$ prédéterminé, font qu'une tension de référence $(V_{ref})$ opposée en polarité à la tension analogique, est appliquée au circuit intégrateur au lieu de la tension analogique, en sorte que le signal de tension de sortie diminue alors constamment à partir de sa valeur de crête atteinte à la fin de l'intervalle de temps prédéterminé, jusqu'à ce que ce signal atteigne une valeur prédéterminée, le signal de sortie digital du convertisseur étant produit au moyen d'un circuit de comptage (4, 5, 10) qui mesure la durée de temps $(T_{I2})$ prise par le signal de tension de sortie pour tomber de la valeur de crête à la valeur prédéterminée, caractérisé en ce que le circuit de comptage comprend un compteur (4) susceptible de fonctionner cycliquement pour compter jusqu'à un nombre prédéterminé et pour produire alors un signal de dépassement (Sd), et en ce que les moyens à micro-ordinateur sont susceptibles de fonctionner pour dériver le signal de sortie digital du compte (Se) enregistré dans le compteur à la fin de ladite durée $(T_{I2})$ et le nombre de tous ces signaux de dépassement fournis par le compteur au cours de cette durée.

2. Convertisseur analogique à digital suivant la revendication 1, dans lequel les moyens à microordinateur sont ajustables sélectivement pour faire varier l'intervalle de temps prédéterminé $(T_{I1})$.

3. Convertisseur analogique à digital suivant la revendication 2, comprenant une mémoire (6) pour emmagasiner plusieurs intervalles de temps prédéterminés $(t_1, t_2...t_n)$ parmi lesquels l'intervalle de temps prédéterminé $(T_{I1})$ peut être choisi.

4. Convertisseur analogique à digital suivant la revendication 1, 2 ou 3, dans lequel le nombre prédéterminé est le compte maximal qui peut être enregistré dans le compteur, le circuit de comptage comprenant également des moyens (10) pour verrouiller le signal de dépassement pour étendre la durée de ce signal.

5. Convertisseur analogique à digital suivant la revendication 1, 2 ou 3, dans lequel le signal de dépassement est procuré par le bit d'ordre le plus élevé dans le compteur.

6. Appareil de pesée électronique comportant un dispositif (A) sensible au poids, pour donner un signal analogique indiquant le poids d'un article à peser, et un convertisseur analogique à digital suivant l'une quelconque des revendications précédentes, connecté pour convertir une tension analogique dérivée de la sortie du dispositif sensible au poids.

7. Appareil suivant la revendication 6, dans lequel la tension analogique appliquée au convertisseur analogique à digital est dérivée de la sortie du dispositif sensible au poids par un circuit amplificateur (B) à gain fixé, connecté entre eux.

# Fig. 1

# Fig. 2

# Fig. 3

# Fig. 4

2

# Fig.5

# Fig.6

# Fig.7

3

# Fig.8

(A) Step 1

Ti / WHAT IS \ T3
DESIGNATED MODE ?
T2

| SET DESIGNATING FLAG TO T1 | SET DESIGNATING FLAG TO T2 | SET DESIGNATING FLAG TO T3 | } Step 2

ANALOG SIGNAL INTEGRATING INTERVAL

PRODUCE COMMAND FOR CHANGING OVER ANALOG SWITCH TO Ia — Step 3

EXECUTE OTHER PROCESSING DURING INTEGRATING INTERVAL CORRESPONDING TO FLAG — Step 4

PRODUCE COMMAND FOR CHANGING OVER ANALOG SWITCH TO Ib, AND PRODUCE COMMAND FOR RESETTING AND STARTING COUNTER — Step 5

REFERENCE VOLTAGE INTEGRATING INTERVAL

EXECUTE PROCESSING FOR PRESCRIBED NUMBER OF STEPS — Step 6

IS Q OUTPUT OF FLIP-FLOP HIGH ? — Step 7 / no

yes

INCREMENT OVERFLOW COUNT AND PRODUCE FLIP-FLOP RESET SIGNAL — Step 8

IS COUNT STOP SIGNAL HIGH ? — Step 9 / no

yes

OFFSET CORRECTION INTERVAL

ENTER AND STORE COUNT RECORDED IN COUNTER — Step 10

CALCULATE TOTAL OUTPUT COUNT OF COUNTER — Step 11

EXECUTE PROCESSING FOR PRESCRIBED NUMBER OF STEPS

(A)

# Fig. 9

FROM STEP 3

Step 4

SET STEP COUNTER TO ZERO — Step 40

EXECUTE PROCESSING FOR
PRESCRIBED NUMBER OF STEPS

T₁

WHAT IS
DESIGNATING FLAG?

T₃

T₂

Step 41

IS NUMBER OF STORAGE
STEPS FOR T₂ EQUAL
TO STEP COUNT IN
STEP COUNTER ?

Yes

No

IS NUMBER OF STORAGE
STEPS FOR T₁ EQUAL
TO STEP COUNT IN
STEP COUNTER ?

Yes

Step 42

No

IS NUMBER OF STORAGE
STEPS FOR T₃ EQUAL
TO STEP COUNT IN
STEP COUNTER ?

Yes

No

INCREMENT STEP COUNTER,
OR COUNT UP PRESCRIBED
NUMBER OF STEPS

Step 43

GO TO STEP 5

# Fig.10

```
        ┌──────────────────┐
        │ SET INTEGRATING  │
        │ INTERVAL         │
        └──────────────────┘
                 │
   ┌──────────────────────────┐
   │ CONVERT SET INTERVAL INTO│
   │ NUMBER OF STEPS, AND STORE│──── Step 01
   │ SAID NUMBER              │
   └──────────────────────────┘
                 │
                (A)
                 │
   ┌──────────────────────────┐
   │ PRODUCE COMMAND FOR CHANGING│──── Step 3
   │ OVER ANALOG SWITCH TO Ia │
   └──────────────────────────┘
                 │
        ┌──────────────────────┐
        │ SET STEP COUNTER TO ZERO │
        └──────────────────────┘
                 │                      ── Step 4'
        ┌ ─ ─ ─ ─ ─ ─ ─ ─ ─ ─ ┐
        │ EXECUTE PROCESSING FOR│
        │ PRESCRIBED NUMBER OF STEPS│
        └ ─ ─ ─ ─ ─ ─ ─ ─ ─ ─ ┘
                 │
          ╱ IS STORED NUMBER OF ╲    Yes
        ◁  STEPS EQUAL TO STEP    ▷────
          ╲ COUNT IN STEP COUNTER ?╱
                 │ No
   ┌──────────────────────────┐
   │ INCREMENT STEP COUNTER,   │
   │ OR COUNT UP PRESCRIBED    │
   │ NUMBER OF STEPS           │
   └──────────────────────────┘
                 │
          GO TO STEP 5 IN FIG. 7
```

# Fig. 11

# Fig. 12

# Fig. 13

# Fig.14

# Fig.15